# DEMANDE DE BREVET EUROPEEN

(11) **EP 2 993 479 A2**
(43) Date de publication de la demande: **09.03.2016**
(21) Numéro de dépôt: 15177753.9
(22) Date de dépôt: 21.07.2015
(51) Int. Cl.: G01R 1/04

(54) **ASSEMBLAGE DE SUPPORT ET/OU DE FIXATION D AU MOINS UN APPAREIL DE MESURE ÉLECTRIQUE**

(30) Priorité: 04.08.2014 FR 1457553
(71) Demandeur: ABB Technology AG, 8050 Zürich (CH)
(72) Inventeur: VILAS BOAS, Armando, 38230 CHARVIEU-CHAVAGNEUX (FR); COUTURIER, Pierre, 38260 NANTOIN (FR)
(74) Mandataire: Verriest, Philippe

(57) **Abrégé**

Boitier (13) d'appareil de mesure électrique (2) destiné à mesurer une grandeur physique représentative d'un courant et/ou d'une tension électrique, le boitier (13) comprenant au mois un organe d'assemblage (31) rapporté sur et/ou ménagé dans une paroi externe (19) du boitier, l'organe d'assemblage (31) présentant un élément de raccordement (31') agencé pour coopérer avec une portion de raccordement (33') d'un élément intermédiaire d'assemblage (33).

## Description

La présente invention concerne un assemblage de support et/ou de fixation d'au moins un capteur d'appareil de mesure électrique.

Des appareils de mesures électriques, comme des capteurs de courant ou de tension sont des dispositifs agencés pour mesurer une intensité électrique traversant un ou plusieurs conducteurs électriques tels qu'un câble ou une barre métallique, ou, respectivement une tension électrique. Ces appareils sont utilisés dans les installations électriques dans un but de surveillance et de régulation.

Pour ce faire, l'appareil de mesure électrique comprend de façon générale un boitier pourvu d'une ouverture traversante destinée au passage du conducteur ou de bornes pour la mesure de tensions. Un élément de mesure d'une intensité ou d'une tension selon les cas, est ménagé dans ou disposé sur le boitier de l'appareil de mesure.

L'appareil de mesure comprend en outre un système électrique agencé pour acquérir les valeurs mesurées par l'élément de mesure. L'élément de mesure est dimensionné pour correspondre à une plage de courants ou de tensions mesurables.

Il est important de pouvoir disposer et fixer l'appareil de mesure électrique à l'endroit souhaité de l'installation électrique dans laquelle il est intégré. Pour ce faire, il est connu d'utiliser des boitiers comprenant des organes de fixation à une surface ou une paroi de l'installation électrique. Selon un exemple, un organe de fixation peut comprendre une extension de la paroi du boitier pourvue d'un orifice pour introduire une vis ou tout autre moyen de fixation.

Cette disposition est satisfaisante dans le sens où il est possible de positionner le boitier du capteur électrique dans l'installation électrique. Cependant, pour une même gamme d'intensités ou de tensions, plusieurs géométries d'organes de fixation sont nécessaires selon l'endroit où doit être positionné le boitier. Le remplacement d'un appareil de mesure électrique peut également se révéler problématique si le boitier de remplacement présente des organes de fixation de dimensions différentes.

La présente invention vise à résoudre tout ou partie des inconvénients mentionnés ci-dessus.

A cet effet, la présente invention concerne un boitier d'appareil de mesure électrique destiné à mesurer une grandeur physique représentative d'un courant et/ou d'une tension électrique, le boitier comprenant au mois un organe d'assemblage rapporté sur et/ou ménagé dans une paroi externe du boitier, l'organe d'assemblage présentant un élément de raccordement agencé pour coopérer avec une portion de raccordement d'un élément intermédiaire d'assemblage.

Un boitier de forme standard peut être utilisé, selon les besoins, avec différents éléments intermédiaires d'assemblage pourvus que ces derniers comprennent une portion de raccordement. Ainsi, la mise en place du d'un appareil de mesure électrique dans une installation électrique est simple puisqu'un élément intermédiaire d'assemblage adéquat peut être utilisé.

Il n'y a plus de limitations dues aux caractéristiques géométriques du boitier pour sa mise en place dans l'installation électrique.

Selon un aspect de l'invention, l'appareil de mesure électrique comprend un capteur de courant destiné à mesurer une intensité électrique parcourant un conducteur, notamment un câble ou une barre métallique, le boitier présentant une ouverture traversante agencée pour permettre le passage dudit conducteur.

Le boitier présente un logement interne disposé autour ou partiellement autour de l'ouverture traversante, transversalement à la direction de passage du conducteur, le logement interne étant destiné à la disposition d'un élément de mesure de champ magnétique autour, respectivement partiellement autour de l'ouverture traversante.

Selon un autre aspect de l'invention, l'appareil de mesure électrique comprend un capteur de tension pourvu de deux bornes de mesure de tension, chacune apte à établir un contact électrique avec un élément externe au boitier, le boitier présentant deux emplacements d'accueil des bornes de mesure de tension ménagés dans la paroi externe.

Selon un aspect de l'invention, l'organe d'assemblage coopère avec la portion de raccordement de l'élément intermédiaire d'assemblage par complémentarité de forme.

L'organe d'assemblage est agencé pour que l'assemblage avec l'élément intermédiaire d'assemblage soit réalisé par une coopération entre ces deux pièces. De préférence le raccordement par complémentarité de forme est réalisé par encliquetage ou insertion.

Selon un aspect de l'invention, l'organe d'assemblage comprend en outre un élément de maintien agencé pour maintenir en position l'élément intermédiaire d'assemblage selon au moins une direction de déplacement de l'élément intermédiaire d'assemblage lorsque l'élément intermédiaire d'assemblage coopère avec l'élément de raccordement de l'organe d'assemblage.

Selon un aspect de l'invention, la paroi externe comprend une portion attenante à l'organe d'assemblage, ladite direction de déplacement étant tangentielle à la direction d'extension de la portion attenante.

Lorsque le boitier et l'élément intermédiaire d'assemblage coopèrent, il n'est pas nécessaire de les bloquer l'un par rapport à l'autre. Toutefois des éléments complémentaires peuvent être prévus pour assurer une meilleure fixation.

Pour la mise en place du boitier et de l'élément intermédiaire d'assemblage dans une installation électrique, le maintien en place selon une direction seulement, par exemple la direction d'extension de la paroi attenante, suffit.

En effet, si l'élément intermédiaire d'assemblage est fixé sur une surface de support de l'installation électrique, un blocage transversal par rapport à la direction de cette surface suffit.

Selon un aspect de l'invention, l'élément de maintien comprend une butée transversale à la direction de déplacement, la butée étant agencée pour maintenir par contact la portion de raccordement transversalement à la direction de déplacement.

La butée est également une aide pour le positionnement de l'élément intermédiaire d'assemblage par rapport au boitier. Lorsque la butée est disposée sensiblement parallèlement à la surface de support de l'installation, la fixation de l'élément intermédiaire à la surface de support permet le maintien en position du boitier.

Selon un aspect de l'invention, le boitier comprend en outre une saillie d'appui rapportée sur une portion de la paroi externe, la saillie d'appui présentant une surface d'appui en regard de ladite portion de paroi externe, la surface d'appui étant agencée pour coopérer avec une surface de support.

La saillie d'appui est apte à être positionnée sur une surface de support de l'installation électrique. Cette disposition est utile pour la mise en place du boitier dans l'installation. La paroi externe n'est ainsi pas en contact direct avec le reste de l'installation électrique.

Selon un aspect de l'invention, une portion de la saillie d'appui du boitier est disposée en regard d'une portion de l'élément de maintien.

Selon un aspect de l'invention, la direction de déplacement est transversale à la surface d'appui.

Cette disposition permet d'associer l'effet de maintien en position par la butée du boitier avec l'élément intermédiaire d'assemblage et le maintien en position de la saillie d'appui sur la surface de support. En effet, la portion de la saillie est prise en étau entre la butée et la surface de support.

Selon un aspect de l'invention, la direction de déplacement est orientée vers la surface d'appui.

La présente invention concerne en outre un appareil de mesure électrique comprenant un boitier tel que décrit ci-avant.

La présente invention concerne également un assemblage de support et/ou de fixation d'au moins un boitier d'appareil de mesure électrique comprenant un boitier d'appareil de mesure électrique tel que décrit ci-avant et au moins un élément intermédiaire d'assemblage agencé pour coopérer avec un élément de raccordement d'un organe d'assemblage du boitier.

L'assemblage de support et/ou de fixation permet, pour un même boitier l'utilisation de différents éléments intermédiaires d'assemblage.

Ainsi il est possible, selon les besoins d'installation de prévoir différents éléments intermédiaires d'assemblage. Il apparait qu'un boitier standard peut être utilisé et qu'il n'est pas nécessaire de prévoir différentes géométries de boitiers correspondant aux différentes contraintes géométriques de mise en place du boitier dans l'installation électrique.

Pour une même gamme de grandeur physique mesurée, il est possible de ne prévoir qu'un seul modèle de boitier. Les contraintes géométriques d'installation, notamment la position de points d'accroche de l'appareil de mesure électrique sur une surface de support sont définis grâce à des éléments intermédiaires d'assemblages interchangeables de géométries différentes.

Selon un aspect de l'invention, l'assemblage de support et/ou de fixation comprend en outre un élément secondaire d'assemblage présentant au moins une portion de fixation amovible agencée pour être assemblée à l'élément intermédiaire d'assemblage.

L'élément secondaire d'assemblage est un élément supplémentaire agencé pour faciliter la disposition du boitier dans l'installation électrique.

Selon un aspect de l'invention, l'élément de fixation secondaire présente une surface d'accueil de la surface d'appui de la saillie d'appui.

Ainsi l'ensemble constitué du boitier et de l'élément intermédiaire d'assemblage n'est pas en contact direct avec une surface de l'installation électrique. Cette disposition est également utile pour décaler l'appareil de mesure électrique de la surface de support de l'installation électrique, par exemple pour que l'ouverture traversante coïncide avec l'emplacement de passage du conducteur.

Selon un aspect de l'invention, l'assemblage de support et/ou de fixation comprend un second élément intermédiaire d'assemblage agencé pour être solidarisé de manière amovible avec l'au moins un élément de fixation intermédiaire d'assemblage et agencé pour être assemblé à un autre boitier d'appareil de mesure électrique.

Selon un aspect de l'invention, la solidarisation amovible du second élément intermédiaire d'assemblage à l'au moins un élément de fixation intermédiaire d'assemblage est réalisée de manière à permettre au moins deux orientations différentes entre lesdits éléments intermédiaires d'assemblage.

De préférence la liaison est de type amovible, il s'agit notamment d'une liaison de type tenon mortaise ou de type queue d'aronde.

Selon un aspect de l'invention, l'assemblage de support et/ou de fixation comprend au moins deux boitiers, chacun apte à être assemblé à un élément intermédiaire d'assemblage, les éléments intermédiaires d'assemblage étant agencés pour être solidarisés de manière amovible.

Il est ainsi possible d'obtenir un assemblage comprenant plusieurs boitiers solidarisés de manière amovible par les éléments intermédiaires d'assemblage.

Selon un aspect de l'invention, la solidarisation de manière amovible des deux éléments intermédiaires d'assemblage est réalisée par un troisième élément intermédiaire d'assemblage, le troisième élément intermédiaire d'assemblage étant agencé pour être solidarisé de manière amovible à au moins deux autres éléments intermédiaires d'assemblage.

De préférence les deux boitiers sont aptes à être positionnés en regard de sorte à ce que leurs ouvertures traversantes soient en regard de manière à permettre le passage d'au moins un conducteur dans les deux ouvertures traversantes.

Selon une autre possibilité, les deux boitiers sont aptes à être positionnés pour permettre le passage de conducteurs présentant des directions de passage parallèles.

De toute façon l'invention sera bien comprise à l'aide de la description qui suit en référence aux dessins schématiques annexés représentant, à titre d'exemple non limitatif, une forme d'exécution de cet assemblage de support et/ou de fixation.
Figure 1 et 1' sont des vues schématiques en perspective d'un d'appareils de mesure électrique disposés dans une installation électrique.
Figure 2, 2' et 3' sont des vues en perspective d'un boitier de capteur de courant.
Figure 3 est une vue de dessus du boitier de capteur de courant.
Figure 4 à 6 sont des vues en perspective de différents éléments intermédiaires d'assemblage.
Figures 7 à 10 sont des vues en perspective d'un assemblage de support et/ou de fixation d'un capteur de courant.
Figure 11 est une vue en perspective d'un élément secondaire d'assemblage.
Figure 12 est une vue en perspective d'un assemblage de support et/ou de fixation comprenant en outre deux éléments secondaires d'assemblage.
Figure 13 est une vue en perspective d'un élément intermédiaire d'assemblage.
Figure 14 est une vue en perspective d'un élément secondaire d'assemblage comprenant un système de fixation à un rail.
Figure 15 est une vue en perspective d'un assemblage de support et/ou de fixation.
Figure 16 est une vue en perspective d'un élément intermédiaire de fixation agencé pour coopérer avec deux boitiers de capteurs de courant.
Figures 17 à 23 sont des vues en perspective d'assemblages de support et/ou de fixation comprenant au moins deux boitiers.

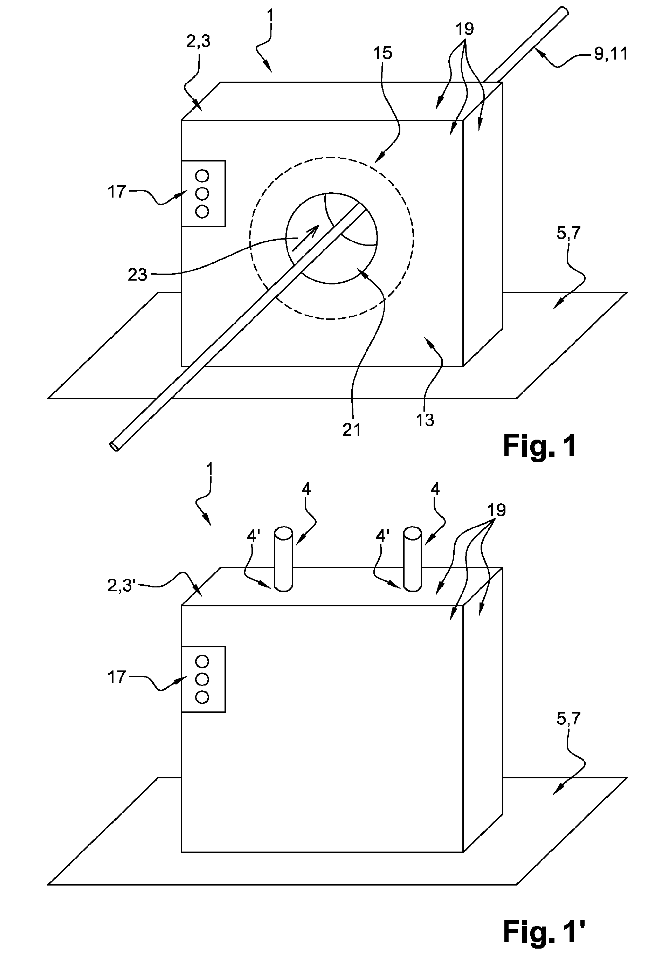

Comme illustré aux figures 1 et 1', un assemblage de support et/ou de fixation 1 est disposé sur une surface de support 5 d'une installation électrique 7.

L'assemblage de support et/ou de fixation 1 comprend un appareil de mesure électrique 2 agencé pour mesurer une grandeur physique représentative d'un courant ou d'une tension électrique.

Comme illustré à la figure 1, l'appareil de mesure électrique 2 peut également comprendre un capteur de courant 3 agencé pour mesurer l'intensité électrique parcourant un conducteur 9. Dans le mode de réalisation présenté, le conducteur 9 est un câble électrique 11. Selon d'autres modes de réalisation, le conducteur électrique 9 peut être une ou plusieurs barres métalliques (par exemple en cuivre ou en aluminium) ou tout autre type de conducteur nécessitant une mesure d'intensité par l'intermédiaire d'un capteur de courant 3.

Le capteur de courant 3 comprend un boitier 13, un élément de mesure de champ magnétique 15 et un système électrique 17 agencé pour contrôler ledit élément de mesure 15. La tension mesurée est fonction de l'intensité électrique traversant le conducteur 9 selon l'effet de Hall. L'élément de mesure de champ magnétique 15 ici présenté est un circuit magnétique. Il peut aussi s'agir de tout autre élément de mesure agencé pour mesurer un champ magnétique comme un autre type de sonde dédiée à cette utilisation.

Le boitier 13 de capteur de courant comprend une paroi externe 19 et présente une ouverture traversante 21. L'ouverture traversante 21 est agencée pour permettre le passage du conducteur 9 selon une direction 23, le boitier 13 étant disposé transversalement à cette direction 23 de passage du conducteur 23.

Comme illustré à la figure 1', l'appareil de mesure électrique 2 comprend, selon une variante de réalisation, un capteur de tension 3' pourvu de deux bornes de mesure de tension 4.

Chacune borne de mesure de tension est apte à établir un contact électrique avec un élément externe au boitier 13. Le boitier 13 présente deux emplacements d'accueil 4' des bornes de mesure de tension ménagés dans la paroi externe 19, les bornes faisant saillie à la paroi externe 19.

Le boitier 13 décrit ci-après est susceptible d'être mis en oeuvre aussi bien pour un appareil de mesure électrique 2 comprenant un capteur de courant 3 tel qu'illustré à la figure 1 qu'un capteur de tension 3' tel qu'illustré à la figure 1'.

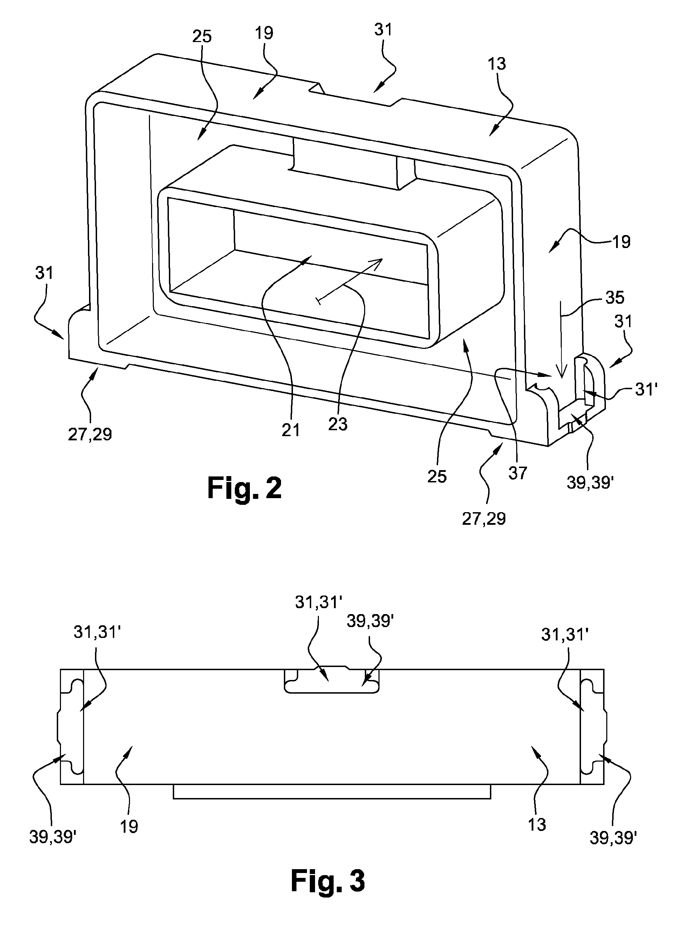

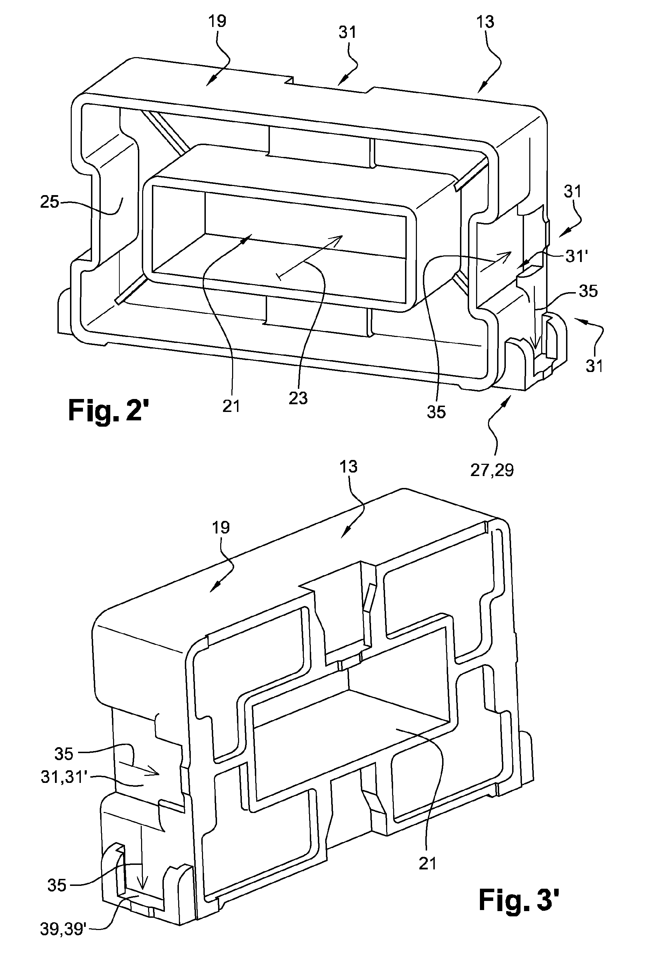

Le boitier 13 comprend en outre un logement interne 25 visible à la figure 2, dans laquelle une portion transversale de la paroi externe 19 a été retirée. Ce logement interne 25 est destiné à accueillir le circuit magnétique 15. Le circuit magnétique 15 est ainsi disposé transversalement à la direction 23 de passage du conducteur 9. Le circuit magnétique 15 entoure le conducteur 9.

Comme illustré à la figure 2 et déjà évoqué, une portion de la paroi externe 19, transversale à la direction de passage du conducteur a été enlevée pour permettre de visualiser l'intérieur du boitier 13, le logement interne 25 apparait ainsi.

Comme illustré aux figures 2 et 3, le boitier 13 comprend deux saillies d'appui 27, chacune rapportée sur une portion de la paroi externe 19.

Chaque saillie d'appui 27 présente une surface d'appui 29 destinée à coopérer avec une surface de support 5 de l'installation électrique 7. La surface d'appui 29 est ainsi destinée à reposer sur la surface de support 5 ce qui permet à la paroi externe 19 de ne pas être en contact direct avec la surface de support 5.

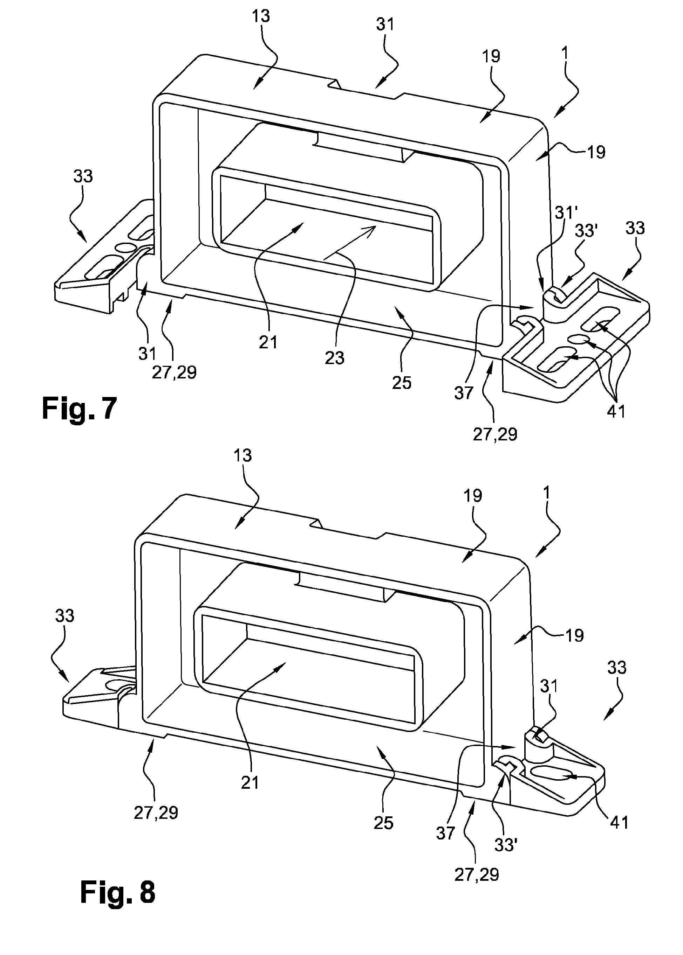

Le boitier 13 comprend en outre trois organes d'assemblage 31. L'assemblage de support et/ou de fixation 1 comprend en outre au moins un élément intermédiaire d'assemblage 33, comme illustré aux figures 7 à 10.

Chaque organe d'assemblage 31 est agencé pour coopérer avec un élément intermédiaire d'assemblage 33. L'élément intermédiaire d'assemblage 33 est destiné à maintenir en position le boitier 13 sur la surface de support 5 de l'installation électrique 7 ou sur le conducteur 9.

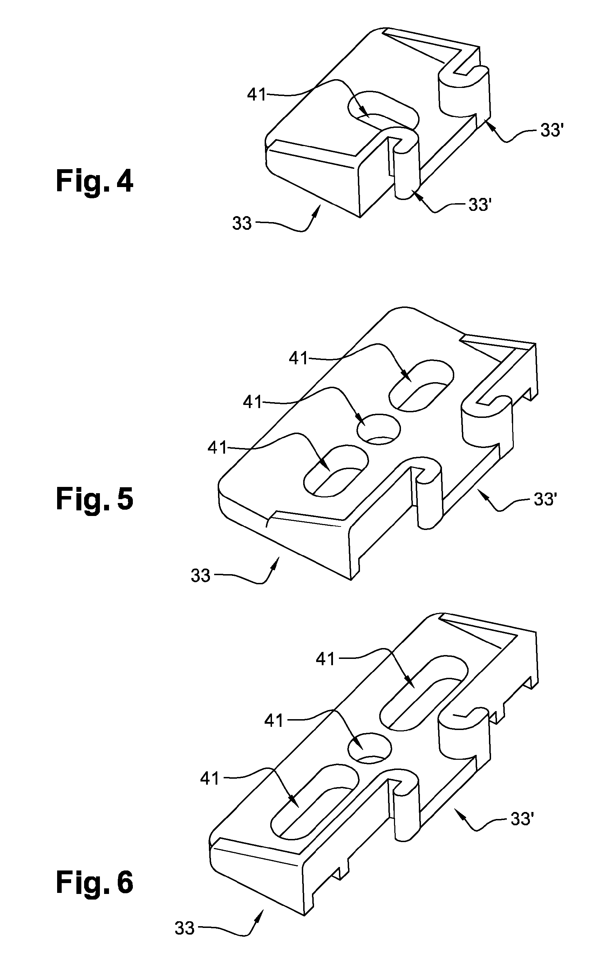

Les figures 4 à 6 présentent des éléments intermédiaires d'assemblage 33 et les figures 7 à 10 des boitiers 13 coopérant avec au moins un élément intermédiaire d'assemblage 33.

Chaque organe d'assemblage 31 présente un élément de raccordement 31' agencé pour coopérer avec une portion de raccordement 33' complémentaire de l'élément intermédiaire d'assemblage 33 associé.

La coopération entre l'élément de raccordement 31' et la portion de raccordement 33' peut, selon les variantes de réalisation, être réalisée par complémentarité de forme ou par l'intermédiaire d'un élément d'association ayant pour rôle d'assurer la cohésion entre l'élément de raccordement 31' et la portion de raccordement 33'.

La coopération par complémentarité de forme peut consister en un système d'encliquetage de la portion de raccordement 33' dans l'élément de raccordement 31'. Il peut aussi s'agir d'un système à queue d'aronde.

Dans le mode de réalisation présenté et comme illustré à la figure 2, la coopération est réalisée par une insertion d'un élément mâle de la portion de raccordement 33' dans un élément femelle de l'élément de raccordement 31'.

La direction de déplacement 35 de la portion de raccordement 33' par rapport à l'élément de raccordement 33' correspond à la direction d'insertion de l'élément mâle dans l'élément femelle. La direction de déplacement 35 est également tangentielle à une portion attenante 37 à l'organe d'assemblage 31 de la paroi externe 19.

Comme illustré aux figures 2' et 3', plusieurs directions de déplacement 35 sont possibles. En pratique et selon la disposition de l'appareil de mesure électrique 2 dans l'installation électrique 7, les directions de déplacement 35 peuvent être horizontales ou verticales.

L'organe d'assemblage 31 comprend en outre un élément de maintien 39 en position selon une direction de déplacement de l'élément intermédiaire d'assemblage 33 par rapport au boitier 13.

Dans le mode de réalisation présenté, la direction selon laquelle l'élément intermédiaire d'assemblage 33 est maintenu en position par rapport au boitier 13 est la direction de déplacement 35.

Il apparait ainsi que lorsque la portion de raccordement 33' est insérée dans l'élément de raccordement 31', un maintien en position est réalisé selon la direction de déplacement 35. Pour ce faire, l'élément de maintien 39 présente une butée 39' disposée transversalement à la direction de déplacement 35.

Comme illustré aux figures 4 à 6, les éléments intermédiaires d'assemblage 33 présentent des ouvertures 41 agencées pour permettre la disposition d'un organe de solidarisation avec la surface de support 5 de l'installation électrique 7 et/ou sur le conducteur 9. Selon un exemple, l'organe de solidarisation peut être une vis.

Dans le mode de réalisation présenté il apparait que la butée 39' est disposée en regard de la surface d'appui 29. Ainsi lorsque l'élément intermédiaire d'assemblage 33 coopère avec le boitier 13 et que l'élément intermédiaire d'assemblage 33 est solidarisé à la surface de support 5, le boitier 13 est plaqué contre la surface de support 5.

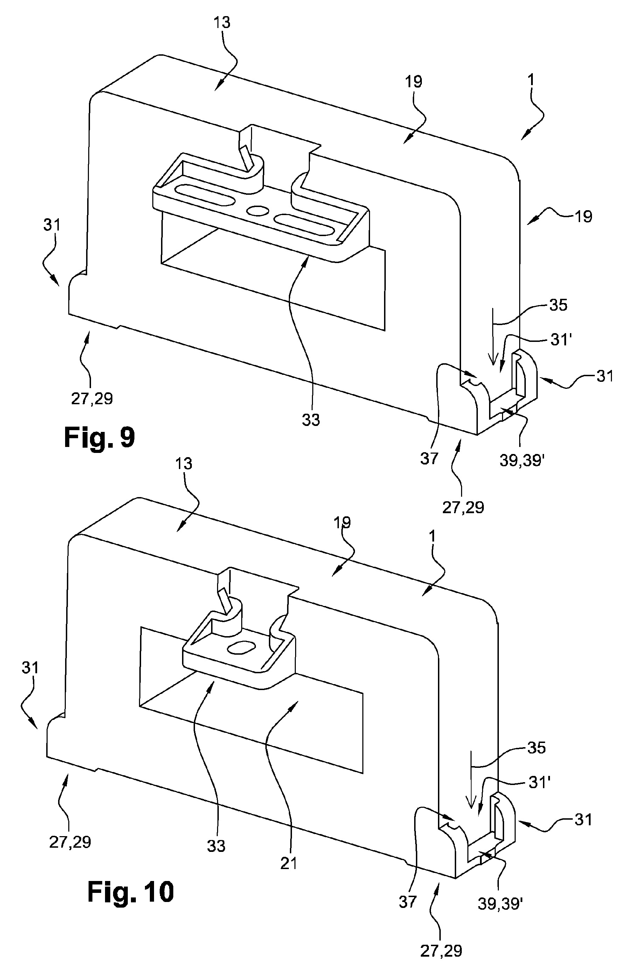

En référence aux figures 9 et 10, aucune saillie n'est positionnée en regard des organes d'assemblage 31 attenants à l'ouverture traversante 21. Toutefois la butée 39' peut jouer le même rôle de plaquage du boitier 13 lorsque l'élément intermédiaire d'assemblage 33 est solidarisé à une autre surface de support 5 de l'installation électrique 7.

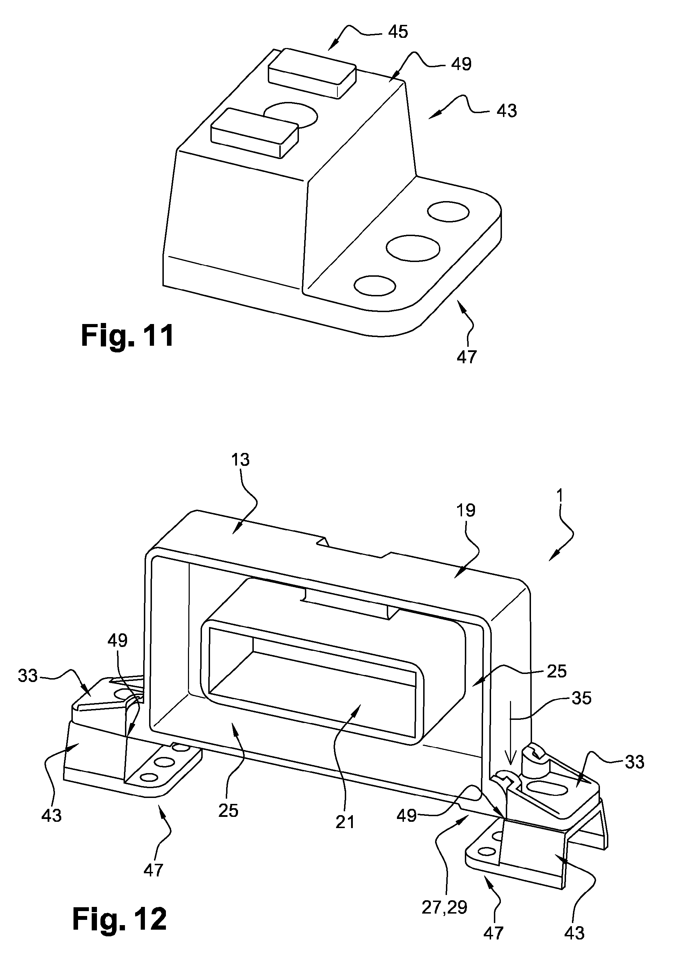

Comme illustré aux figures 11 à 15, l'assemblage de support et/ou de fixation 1 peut comprendre des éléments secondaires d'assemblages 43 destinés à faciliter le positionnement et la fixation du boitier 13 dans l'installation électrique 7 et/ou sur le conducteur 9.

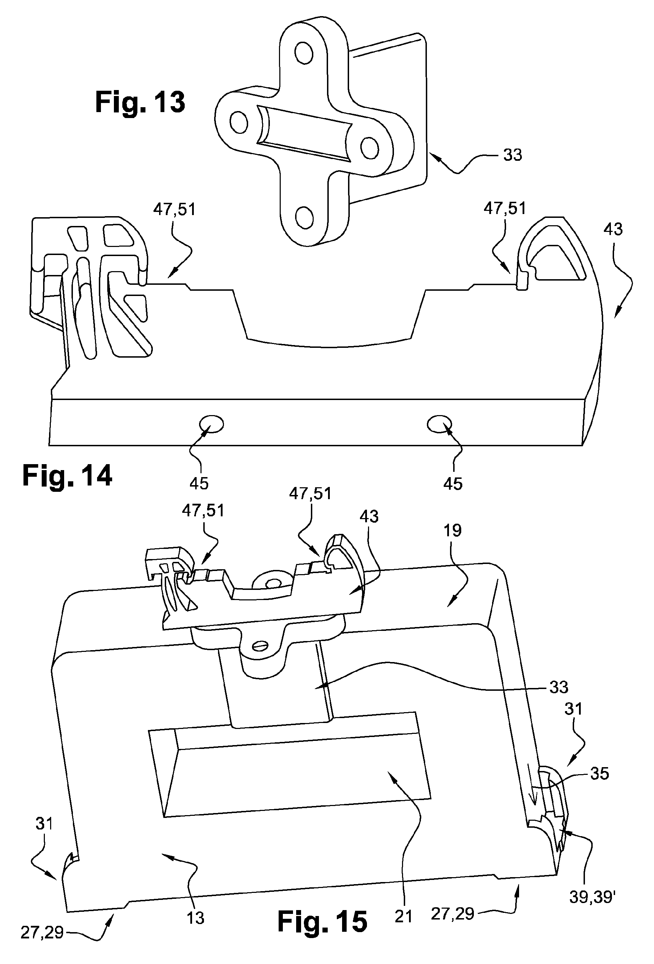

Comme illustré aux figures 11 et 15, chaque élément secondaire d'assemblage 43 comprend une portion de fixation amovible 45 avec un élément intermédiaire d'assemblage 33.

Chaque élément secondaire d'assemblage 43 comprend également une portion 47 destinée à être fixée à une surface de support 5 ou tout autre élément de l'installation électrique 7, comme illustré aux figures 11 et 12.

Selon un premier exemple, illustré aux figures 11 et 12, des moyens de fixation amovibles de type vis et écrous peuvent être utilisés pour solidariser de manière amovible l'élément intermédiaire d'assemblage 33 et l'élément secondaire d'assemblage 43, ces derniers présentant chacun des ouvertures en regard une fois assemblés.

L'élément intermédiaire d'assemblage 33 présente en outre une surface d'accueil 49 agencée pour coopérer avec une portion de la surface d'appui 29. Cette disposition permet, comme illustré à la figure 12, de maintenir le boitier 13 plaqué contre l'élément secondaire d'assemblage 43 lorsque l'élément intermédiaire d'assemblage 33 et l'élément secondaire d'assemblage 43 sont solidaires. Le boitier 13 est ainsi pris en étau entre l'élément intermédiaire d'assemblage 33 et l'élément secondaire d'assemblage 43.

Selon un deuxième exemple, illustré aux figures 13 à 15, un élément secondaire de fixation 43 comprend une portion de fixation amovible 45 avec un élément intermédiaire d'assemblage 33 d'une part et un système de solidarisation à un rail 51 d'autre part.

Le système de solidarisation à un rail 51 est ainsi un moyen de maintien en position supplémentaire du boitier 13. L'astuce est ici d'utiliser un rail de l'installation électrique 7, comme élément de raccord du boitier 13.

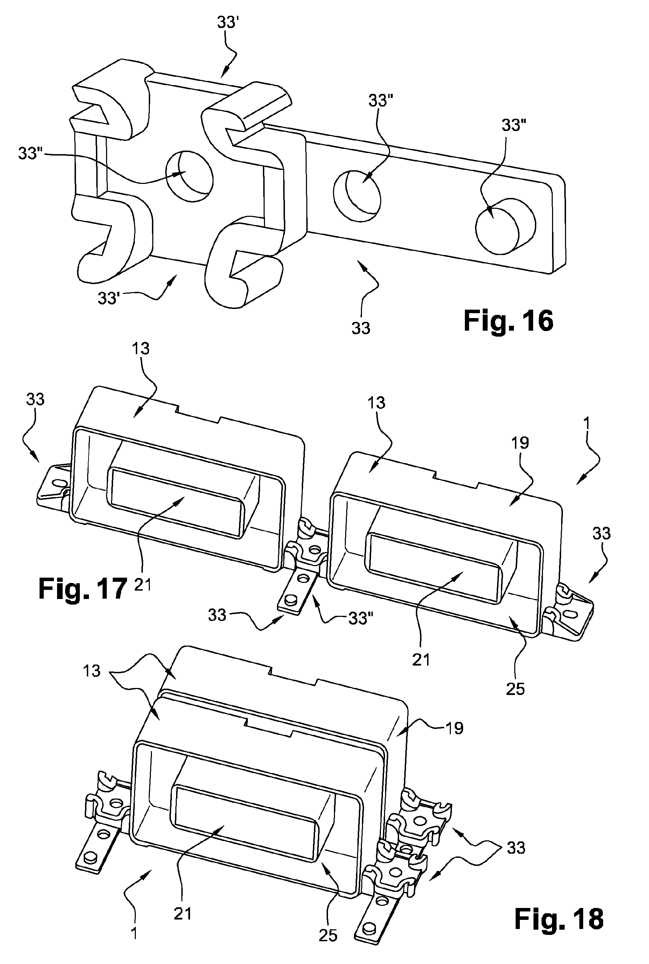

Comme illustré à la figure 16, un élément intermédiaire d'assemblage 33 peut comprendre deux portions de raccordement 33' et une portion d'assemblage 33" à un autre élément intermédiaire d'assemblage 33. Les portions d'assemblage 33" de deux éléments intermédiaires d'assemblage 33 est de type tenon/mortaise dans le mode de réalisation présenté.

Les portions d'assemblage 33" peuvent être agencées pour coopérer selon plusieurs orientations de manière à adapter facilement le positionnement des boitiers 13.

Dans le mode de réalisation présenté, et comme illustré aux figures 17 à 23, l'assemblage de support et/ou de fixation 1 peut comprendre plusieurs boitiers 13, par exemple deux ou trois.

Il apparait ainsi, grâce aux dispositions expliquées plus haut que les boitiers 13 peuvent être disposés les uns par rapport aux autres selon plusieurs orientations.

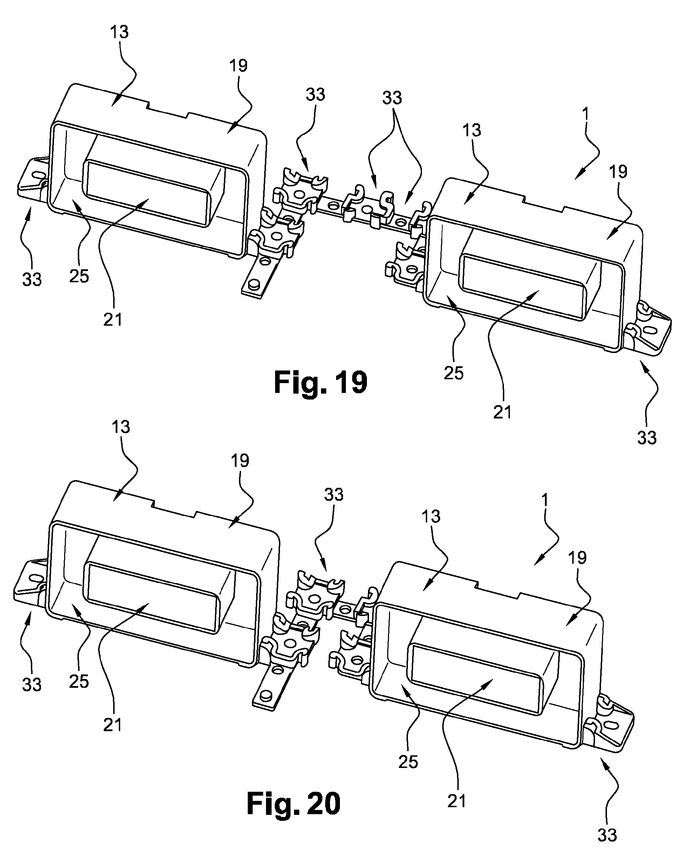

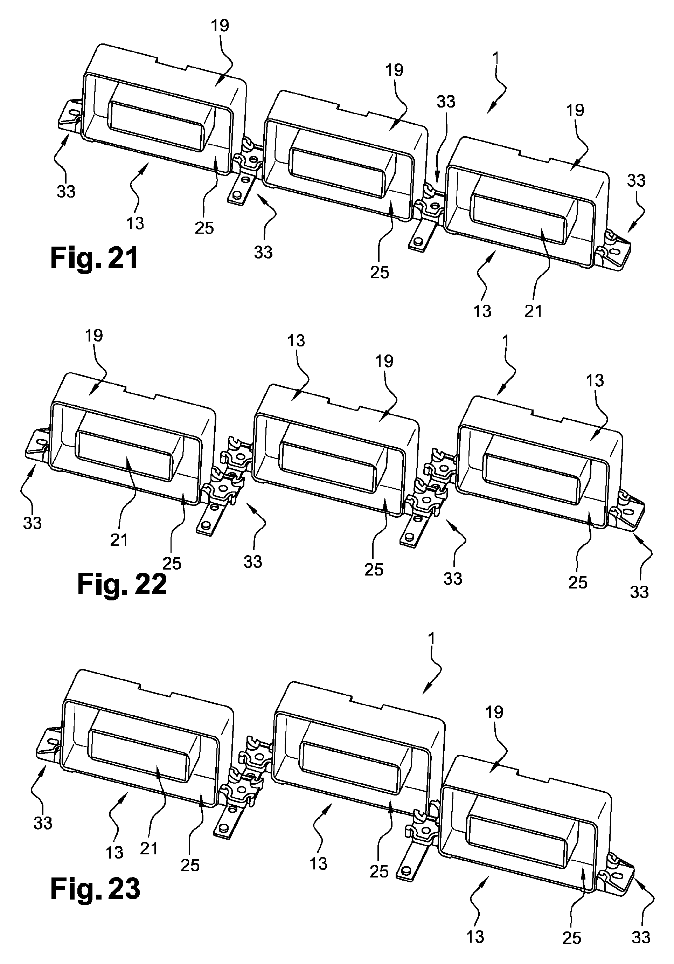

Les boitiers 13 peuvent être alignés, comme représentés aux figures 1 7et 18. Les boitiers peuvent être disposés à distance tout en appartenant au même assemblage de support et/ou de fixation, comme représenté aux figures 19 et 20. Les figures 21 à 23 illustre un assemblage de support et/ou de fixation comprenant trois boitiers 13.

Il ressort du présent texte que la conception modulaire présentent des avantages tant pour la mise en place de l'appareil de mesure électrique 2 dans des installations électriques 7 que pour la standardisation des dimensions des boitiers 13.

En effet, une seule taille de boitier 13 suffit pour toutes les configurations : comme les moyens de fixation ne sont pas compris dans le boitier 13, il n'est pas nécessaire de prévoir des boitiers avec les moyens de fixation de dimensions différentes. La même remarque s'applique pour les assemblages de support et/ou de fixation 1 comprenant plusieurs boitiers 13.

L'assemblage de support et/ou de fixation permet également d'adapter les moyens de fixation d'un boitier à une installation existante pour remplacer un appareil de mesure électriquede géométrie différente. Dans ce cas, si des trous ont déjà été percés dans une paroi de l'installation électrique pour la fixation dudit appareil, il est possible de réutiliser ces trous pour adapter l'assemblage de support et/ou de fixation présenté.

Comme il va de soi, l'invention ne se limite pas à la seule forme d'exécution de cet assemblage de support et/ou de fixation, décrit ci-dessus à titre d'exemple, elle en embrasse au contraire toutes les variantes de réalisation.

## Revendications

1. Boitier (13) d'appareil de mesure électrique (2) destiné à mesurer une grandeur physique représentative d'un courant et/ou d'une tension électrique, le boitier (13) comprenant au mois un organe d'assemblage (31) rapporté sur et/ou ménagé dans une paroi externe (19) du boitier, l'organe d'assemblage (31) présentant un élément de raccordement (31') agencé pour coopérer avec une portion de raccordement (33') d'un élément intermédiaire d'assemblage (33).

2. Boitier (13) d'appareil de mesure électrique (2) selon la revendication 1, dans lequel l'appareil de mesure électrique (2) comprend un capteur de courant destiné à mesurer une intensité électrique parcourant un conducteur (9), notamment un câble ou une barre métallique, le boitier (13) présentant une ouverture traversante (21) agencée pour permettre le passage dudit conducteur (9),
le boitier (13) présentant un logement interne (25) disposé autour ou partiellement autour de l'ouverture traversante (21), transversalement à la direction (23) de passage du conducteur (9), le logement interne (25) étant destiné à la disposition d'un élément de mesure de champ magnétique (15) autour, respectivement partiellement autour de l'ouverture traversante (21).

3. Boitier (13) d'appareil de mesure électrique (2) selon l'une des revendications précédentes, dans lequel l'appareil de mesure électrique (2) comprend un capteur de tension pourvu de deux bornes de mesure de tension (4), chacune apte à établir un contact électrique avec un élément externe au boitier (13), le boitier (13) présentant deux emplacements d'accueil (4') des bornes de mesure de tension (4) ménagés dans la paroi externe (19).

4. Boîtier (13) d'appareil de mesure électrique (2) selon l'une des revendications précédentes, dans lequel l'organe d'assemblage (31) coopère avec la portion de raccordement (33') de l'élément intermédiaire d'assemblage (33) par complémentarité de forme.

5. Boitier (13) d'appareil de mesure électrique (2) selon l'une des revendications précédentes, dans lequel l'organe d'assemblage (33) comprend en outre un élément de maintien (39) agencé pour maintenir en position l'élément intermédiaire d'assemblage (33) selon au moins une direction de déplacement (35) de l'élément intermédiaire d'assemblage (33) lorsque l'élément intermédiaire d'assemblage (33) coopère avec l'élément de raccordement (31') de l'organe d'assemblage (31).

6. Boitier (13) d'appareil de mesure électrique (2) selon l'une des revendications précédentes, comprenant en outre une saillie d'appui (27) rapportée sur une portion de la paroi externe (19), la saillie d'appui (27) présentant une surface d'appui (29) en regard de ladite portion de paroi externe (19), la surface d'appui (27) étant agencée pour coopérer avec une surface de support (5).

7. Boitier (13) d'appareil de mesure électrique (2) selon la revendication 6, dans lequel une portion de la saillie d'appui (27) du boitier (13) est disposée en regard d'une portion de l'élément de maintien (39).

8. Boitier (13) d'appareil de mesure électrique (2) selon l'une des revendications 6 ou 7, dans lequel la direction de déplacement (35) est transversale à la surface d'appui (29).

9. Boitier (13) d'appareil de mesure électrique (2) selon la revendication 8, dans lequel la direction de déplacement (35) est orientée vers la surface d'appui (29).

10. Assemblage de support et/ou de fixation (1) d'au moins un boitier (13) d'appareil de mesure électrique (2) comprenant :
- un boitier (13) d'appareil de mesure électrique (2) selon l'une des revendications précédentes,
- au moins un élément intermédiaire d'assemblage (33) agencé pour coopérer avec un élément de raccordement (31') d'un organe d'assemblage (31) du boitier (13).

11. Assemblage de support et/ou de fixation (1) selon la revendication 10, comprenant en outre un élément secondaire d'assemblage (43) présentant au moins une portion de fixation amovible (45) agencée pour être assemblée à l'élément intermédiaire d'assemblage (33).

12. Assemblage de support et/ou de fixation (1) selon l'une des revendications 10 ou 11, comprenant un second élément intermédiaire d'assemblage (33) agencé pour être solidarisé de manière amovible avec l'au moins un élément de fixation intermédiaire d'assemblage (33) et agencé pour être assemblé à un autre boitier (13) d'appareil de mesure électrique (2).

13. Assemblage de support et/ou de fixation (1) selon l'une des revendications 10 à 12, comprenant au moins deux boitiers (13), chacun apte à être assemblé à un élément intermédiaire d'assemblage (33), les éléments intermédiaires d'assemblage (33) étant agencés pour être solidarisés de manière amovible.

14. Assemblage de support et/ou de fixation (1) selon la revendication 13, dans lequel la solidarisation de manière amovible des deux éléments intermédiaires d'assemblage (33) est réalisée par un troisième élément intermédiaire d'assemblage (33), le troisième élément intermédiaire d'assemblage (33) étant agencé pour être solidarisé de manière amovible à au moins deux autres éléments intermédiaires d'assemblage (33).
